# EUROPEAN PATENT SPECIFICATION

(11) **EP 0 801 793 B1**
(45) Date of publication and mention of the grant of the patent: **25.07.2001**
(21) Application number: 95940599.4
(22) Date of filing: 03.11.1995
(51) Int. Cl.: G11B 5/84, C23C 14/54

(54) **SPUTTERED THERMALLY CYCLED TEXTURE LAYERS FORMED OF HIGH MELTING POINT MATERIALS**
UNTER ZYKLISCH VERÄNDERTEN TEMPERATUREN KATHODENZERSTÄUBTE STRUKTURIERUNGSSCHICHTEN AUS MATERIALIEN MIT HOHEM SCHMELZPUNKT
COUCHES TEXTUREES ORGANISEES EN CYCLES, THERMIQUEMENT EVAPOREES ET FORMEES DE MATERIAUX A POINT DE FUSION ELEVE

(43) Date of publication of application: 22.10.1997
(73) Proprietor: Seagate Technology LLC, Scotts Valley, CA 95066 (US)
(72) Inventor: GAO, Chuan, Fremont, CA 94539 (US); MASSEY, Darrin, Fremont, CA 94538 (US)
(74) Representative: Kenyon, Sarah Elizabeth
(86) International application number: US9514225
(87) International publication number: WO9716826

(56) References cited:
- EP-A- 0 574 835
- EP-A- 0 651 380
- US-A- 4 747 928

## Description

### BACKGROUND OF THE INVENTION

The present invention relates to media for recording, storing and reading magnetic data, and more particularly to means for controlling the surface topographies of magnetic media.

Magnetic disks employ thin films of magnetizable material for storing data in magnetic form. Typically, the magnetic disks are rotatably mounted, with one or more magnetic data transducing heads positioned in close proximity to the recording surfaces of the disks. Each transducing head is movable generally radially relative to its associated disk as the disk is rotated. Rigid magnetic disks are rotated at high speeds during reading and recording operations, to create an air cushion or bearing that supports each transducing head at a controlled distance from its associated recording surface, thus to maintain a consist head glide height or flying height. Also, there are times when the transducing heads contact their associated disks; in particular when the disks are stationary, during disk acceleration from a stop, and during deceleration toward a complete stop.

To increase magnetic data storage density it is desirable to minimize the transducing head flying height. To achieve low flying heights, the recording surface must be flat and smooth, but not so smooth as to cause head media interface stiction. As a result, recording surfaces of magnetic media are intentionally provided with a texture, selected to provide low glide height yet minimize friction and wear.

Traditionally, mechanical abrasion has been used for this purpose. Typically, a cloth, paper or pad coated or saturated with a suitable grit is used. Abrasion removes substantial amounts of substrate material and takes considerable time, adding substantially to media production costs. The abrasion process is low precision, and vulnerable to defect generation.

While mechanical texturing is predominant in commercially available media, chemical etching and printing techniques have been employed to provide texture. More recently, laser energy has been disclosed for media texturing, e.g. as in U. S. Patent No. 5,108,781 (Ranjan et al.). A pulsed laser beam is focused upon the upper surface of an aluminum nickel-phosphorous substrate to form laser marks, each with a central depression surrounded by a raised rim. As disclosed in application Serial No. PCTUS95/10697 entitled "PULSED LASER SURFACE TREATMENTS FOR MAGNETIC RECORDING MEDIA", filed August 22, 1995, and assigned to the assignee of this application, laser energy can be used to create outwardly projecting nodules, and to polish a substrate surface. The technique is applied to aluminum Ni-P substrates, and to metallic layers formed on glass substrates.

The continuing trend toward higher data recording densities has lead to the use of alternatives to the traditional aluminum Ni-P substrate, e.g. glass, glass ceramics, and quartz (SiO₂). Although these substrates can be mechanically abrated, the problems discussed above in connection with aluminum Ni-P substrates, particularly low precision and defect generation, are more serious in the case of the non-metallic substrates.

Low melting point materials have been sputtered onto non-wetting substrates to provide texture. For example, gallium has been sputtered onto glass substrates while being maintained above its melting point of 29.8° C. Due to surface tension, the deposited Ga forms spherical liquid features. Subsequent deposition of a magnetic film form alloys and intermetallics that solidify the gallium layer and replicate its topography. An alloy of indium and tin has been applied in a similar manner. Such low melting point materials, however, cannot be applied in a manner that provides separation between adjacent bumps. Further, substrates must be mechanically textured before these materials are sputtered, or the substrate material must have some kind of intrinsic "built-in" texture (such as glass-ceramic substrates discussed immediately below). In connection with glass substrates, several alternative texturing techniques have been attempted, including spin coating, etching, sputtering, and annealing. These have been less than satisfactory in general.

In connection with glass ceramic substrates, mechanical abrasion can cause a "built in" texture in the substrate by removing previously embedded hard particulates. This built in texture is comprised of multiple pits surrounded by "volcanic" rims. Substrates textured in this manner have performed well in CSS testing. However, because of the porosity of metal films deposited onto these substrates, mobile alkali ions (e.g. K⁺, Na⁺, and Ca⁺ ions), particularly adjacent the pits, have been found to migrate from the glass ceramic substrate into the film and ultimately to the exposed surface of the metal films. This problem, known as "hazing" can be diminished by forming the metal film at a highly increased density and by eliminating the pits. However, achieving the built in texture under these circumstances has been difficult, and CSS and stiction performance has not been satisfactory.

Therefore, it is an object of the present invention to provide a more repeatable and reliable method of texturing substrates for magnetic disks utilizing a variety of non-magnetic substrates.

It also is an object to provide a media fabrication process applicable to all types of substrates, that is much simpler and much less costly than conventional texturing and other substrate texturing techniques currently under development.

Another object is to provide a magnetic disk texturing process that is clean room compatible and minimizes the need to handle substrates, to reduce the chances for defects and contamination.

A further object is to provide a magnetic disk having a more uniform texture and fewer defects.

Another object is to provide a substrate texturing process that affords control over the spacing between adjacent bumps or other features, leading to improved CSS performance.

Yet another object is to provide a magnetic disk having a texture that allows lower transducing head flying heights (i.e. one microinch (25,4 nm) or less), yet enhances CSS performance.

### SUMMARY OF THE INVENTION

To achieve these and other objects, there is provided a process for forming a texture on a non-magnetic substrate, as defined in appended claim 1 Further, a magnetic data storage medium according to the invention is defined in appended claim 16.

Preferably, the temperature change and the deposition of the texturing material occur simultaneously. This approach advantageously employs a heat source to elevate the substrate temperature to a value equal to or greater than the initial temperature, just prior to deposition. The initial temperature can be in the range of about 200 to 600°C., depending on the substrate material and desired bump density, height and diameter. The temperature more preferably is in the range of 200 to 400°C. Upon initiation of deposition, the heat source is removed, allowing the substrate to cool as deposition proceeds.

The texturing material can be deposited by sputtering within a vacuum chamber at a deposition pressure in the range of about 3-50 millitorr (0.40-6.67 Pa). The thin film can be sputtered to a thickness of up to about 500 nm, and more preferably in the range of 50-300 nm.

As deposition proceeds, both the substrate and the thin film contract due to their cooling. Having different thermal expansion coefficients, they contract at different rates, which introduces mechanical stresses in the thin film.

The first linear thermal expansion coefficient is greater than the second, so that cooling leads to compressive mechanical stresses in the thin film. Multiple discontinuities are formed throughout the thin film once the mechanical stresses exceed the elastic limit of the texturing material.

A surprising and advantageous result is that the multiple local discontinuities consist substantially of smoothly rounded, dome-like bumps. The bumps are relatively uniform in height, and are distributed substantially uniformly throughout the thin film. The preferred materials for the texturing layer are metals, e.g. titanium, tungsten, chromium, aluminum, gold, silver, and tantalum, or binary alloys of these metals. Titanium and tungsten are particularly preferred, due to their high density.

The bumps tend to have diameters in the range of 1-3 microns, and heights up to 100 nm, more preferably in the range of 7-20 nm. The size of the bumps varies with the selection of the texturing material, but can be controlled by adjusting the substrate temperature when sputtering is initiated and the sputtering pressure, and by controlling the film thickness and the cooling rate. Thicker films, higher initial substrate temperatures, lower sputtering pressures and longer cooling times produce larger bumps. Thus, the process is repeatable to yield thin film texturing layers with a desired average roughness and average bump height, and with a high degree of uniformity.

Another advantage of the texturing process is its compatibility with the usual post-texturing steps in media fabrication. With the non-magnetic substrate in a deposition chamber, the application and texturing of the thin film texture material can be followed by deposition of an underlayer, a thin film of a magnetic recording material, and a protective cover layer, all in a continuous process. There is no need for a mechanical abrasion step or any other texturing step requiring treatment of the substrate outside of the deposition chamber. This substantially reduces the cost of media fabrication by eliminating a treatment step, and also reduces the chance for contamination during fabrication.

After deposition of the texturing material, the substrate and thin film can be reheated to a temperature of at least about 150°C., and then allowed to cool. The reheating step tends to smooth out the bumps, to improve wear characteristics of the textured surface.

The process has been used to form texturing thin films on a variety of substrates, including aluminum Ni-P, glass, glass ceramic, and quartz substrates. The disks exhibit good CSS performance at glide heights of less than about 1 microinch (25 nm). Disks including glass, glass ceramic and quartz substrates show high resistance to haze corrosion when tested at 100% relative humidity. Thus in accordance with the present invention, media reliability and wear characteristics are enhanced by a process utilizing differences in coefficients of thermal expansion and in surface energies, to produce repeatable and reliable texturing in connection with a variety of non-magnetic substrates.

### IN THE DRAWINGS

For a further understanding of the above and other features and advantages, reference is made to the following detailed description and to the drawings, in which:
Figure 1 is a plan view of a rigid magnetic disk formed according to the present invention, and a transducing head supported for generally radial movement relative to the disk;
Figure 2 is an enlarged partial sectional view of the magnetic disk in Figure 1;
Figure 3 is a schematic view of a vacuum deposition apparatus utilized in fabricating the magnetic disk, with a non-magnetic substrate enclosed within the chamber;
Figures 4-7 illustrate the substrate during fabrication of the recording medium;
Figure 8 and 9 depict Tencor measurement surface profiles of recording media textured according to the present invention;
Figures 10-15 are charts depicting CSS performance of two examples of the recording medium;
Figures 16-19 are optical micrographs of texture layers sputtered on four different non-magnetic substrates;
Figures 20-22 illustrate an alternative recording medium with a texture layer covering only part of the substrate surface, supported on a platform that more rapidly cools the substrate; and
Figure 23 illustrates a further alternative example of a recording medium, in which a texturing layer is applied to a substrate having a lower linear coefficient of thermal expansion.

### DETAILED DESCRIPTION OF THE PREFERRED EMBODIMENTS

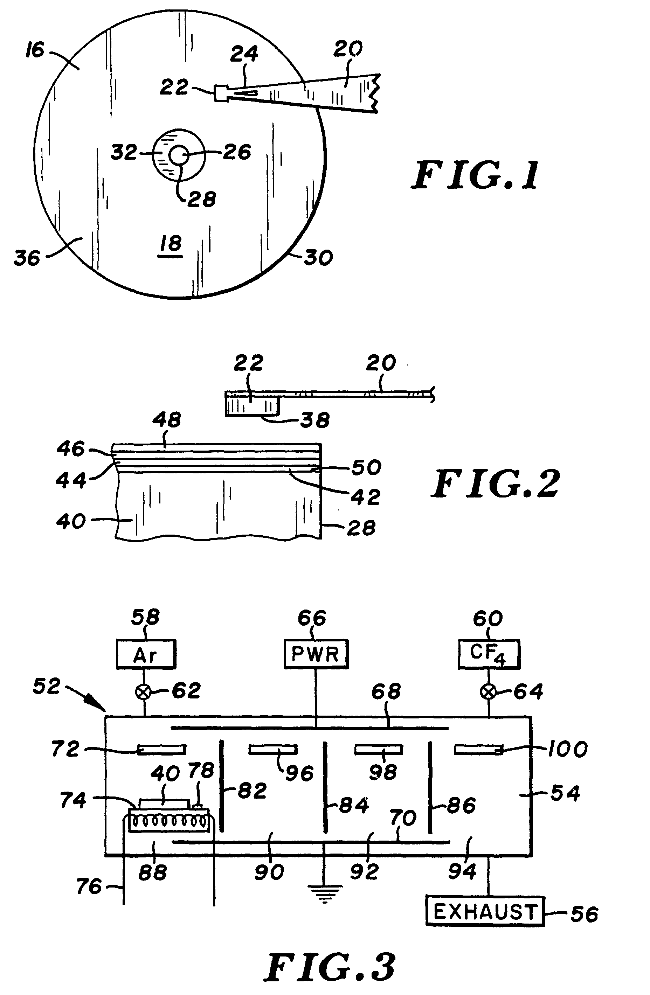

Turning now to the drawings, there is shown in Figures 1 and 2 the medium for recording and reading magnetic data, in particular a magnetic disk 16 rotated about a vertical axis and having a substantially planar and horizontal upper surface 18. A rotary actuator (not shown) includes a transducing head support arm 20 supported in cantilevered fashion above the magnetic disk. A magnetic data transducing head 22 is mounted to the free end of the support arm, through a suspension 24 which allows gimballing action of the head. The rotary actuator and the support arm pivot to move head 22 in an arcuate path, generally radially with respect to disk 16.

At the center of the disk is an opening 26 to accommodate a disk drive spindle (not shown) used to rotate the disk. An inner rim 28 defines the opening. Between the opening and an outer rim 30 of the disk, upper surface 18 includes an annular radially inward region 32 where disk 16 is clamped to the spindle, and an annular data zone 36 providing the area for recording and reading the magnetic data.

When disk 16 is at rest, or rotating at a speed substantially below its normal operating range, transducing head 22 contacts upper surface 18. When the disk rotates within its normal operating range, an air bearing or cushion is formed by air flowing between the head and the upper surface in the direction of disk rotation. The air bearing supports the head in parallel, spaced apart relation to the recording surface. Typically the "glide height", i.e. the distance between a planar bottom surface 38 of head 22 and upper surface 18, is about 1 to 2 microinches (25 to 51 nm). A low glide height is preferred, since reducing the glide height increases the density at which data can be stored. For recording and reading, disk rotation and rotary arm pivoting are controlled in concert to selectively position transducing head 22 near desired locations within data zone 36.

As seen from Figure 2, disk 16 is formed of a substrate disk 40 and multiple thin film layers applied to the substrate including a texture layer 42 applied to the substrate an underlayer 44, a magnetic recording layer 46, and a protective cover layer 48.

Substrate 40 preferably is a disk formed of a glass, a glass ceramic, or quartz (SiO₂), and also can be an aluminum substrate plated with a nickel-phosphorous alloy. The initial fabrication step involves polishing, grinding or otherwise machining the substrate disk to provide a substantially flat and smooth upper substrate surface 50. For further processing, the substrate disk is placed within a vacuum deposition apparatus.

An example of an apparatus suitable for vacuum deposition is schematically illustrated at 52 in Figure 3. The apparatus includes a fluid tight plasma chamber 54. An exhaust pump 56 is in fluid communication with chamber 54 for evacuating the chamber when desired. Also in fluid communication with the chamber are a container 58 for supplying argon or another inert gas, and a container 60 for supplying a reactive gas such as hydrogen. Valves 62 and 64 control the supply of their respective gases to the plasma chamber.

A power supply 66 biases a cathode electrode 68 while another electrode 70 is maintained at ground, to generate an electrical field to ionize argon and other gases within plasma chamber 54. A target 72 formed of titanium or another appropriate metal texturing material is positioned near electrode 68.

Substrate 40 is supported on a platform 74 near grounded electrode 70. A heating element 76, running through the platform, is operable to heat the platform and thus to heat the substrate. A temperature sensor 78, mounted on platform 74 near substrate 40, provides an indication of the substrate temperature.

Several partitions 82, 84 and 86 divide plasma chamber 54 into subchambers or stations 88, 90, 92, and 94 for respectively applying the texture layer, underlayer, magnetic recording layer and protective layer. For applying the underlayer, subchamber 90 contains a target 96 formed of a suitable underlayer material such as chromium. Subchamber 92 contains a target 98 formed of a magnetic thin film recording material, e.g. CoNiCr or CoCrTa, and subchamber 94 contains a target 100 formed of carbon. Partitions 82, 84 and 86 isolate the stations from one another sufficiently to enable each deposition to proceed under conditions favorable to the particular material involved. While just one power supply 66 is shown, the individual stations can have separate power supplies and cathode electrodes to enhance fabrication process control.

With substrate 40 on platform 74 as shown in Figure 3, exhaust pump 56 is actuated to substantially evacuate plasma chamber 54. Following evacuation, valve 62 is opened to supply argon to the chamber, until pressure within the chamber reaches a predetermined value, e.g. 10 millitorr (1.33Pa). Heating element 76 is actuated to heat substrate 40 to a predetermined initial sputtering temperature in the range of 200-600° C., and more preferably in the range of 200-400° C. The substrate is heated to at least the selected initial temperature before sputtering begins.

With the substrate sufficiently heated and argon at the intended pressure, power is provided to electrode 68 at a desired level, e.g. 40 watts per square centimeter, to generate an electrical field and ionize the argon, thus forming an argon plasma within the chamber. The electrical field accelerates the argon ions onto texturing target 72, sputter depositing titanium onto the exposed annular portion of substrate surface 50. Vacuum deposition continues until texture layer 42 has reached a predetermined thickness in the range of about 50-500 nm and more preferably 50-300 nm.

Heating element 76 is inactive during deposition. Consequently, substrate 40 undergoes cooling as texture layer 42 is deposited and continues to cool following deposition. Substrate 40 and texture layer 42 contract as they cool, but at different rates. More particularly, substrate 40 being formed of glass has a linear thermal expansion coefficient in the range of 10-12 X 10⁻⁶/degree C. Titanium texture layer 42 has a thermal expansion coefficient in the range of 7-8 X 10⁻⁶/degree C. Accordingly, although the substrate and texture layer experience the same temperature change as they cool, substrate 40 experiences greater contraction.

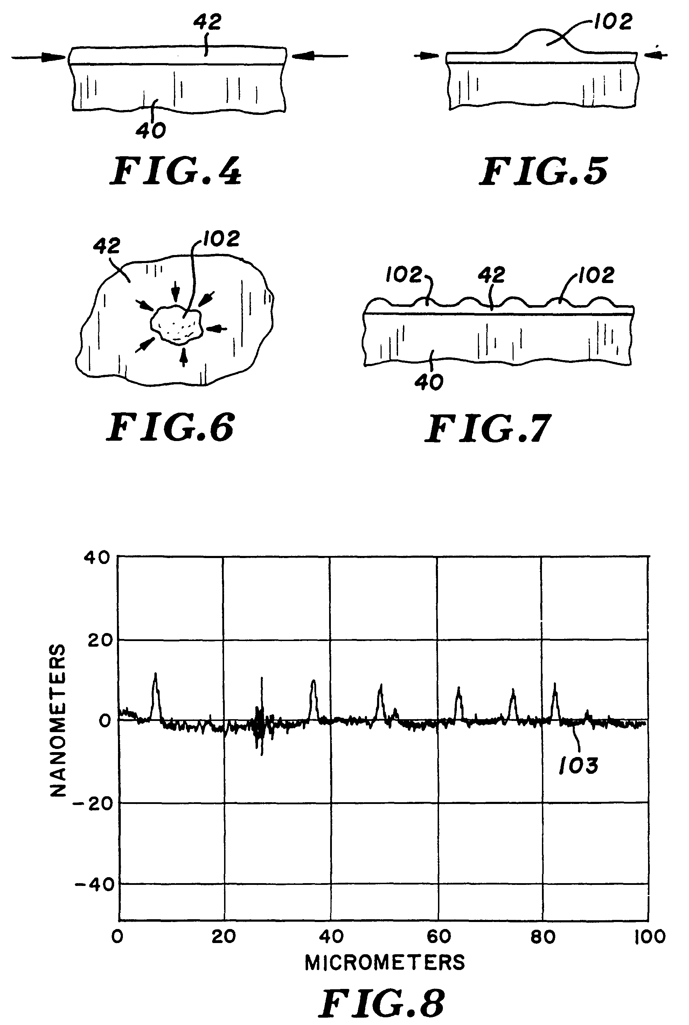

Because of the adhesion of a texture layer and substrate along their interface, the difference in their contraction causes both to experience mechanical stress. The stress, i.e. tension in the substrate and compression in the texture layer, initially counteract one another. However, because texture layer 42 is extremely thin compared to the substrate, the effects of the counterbalancing forces are concentrated in the texture layer. The compressive stresses, which act in all directions, are represented by arrows in Figure 4.

As the substrate and texture layer continue to cool and contract, the compressive forces increase to the point of exceeding the elastic limit of the texturing material. This may occur either during or just after deposition. Throughout texture layer 42, plastic deformation relieves the compressive stress, simultaneously relieving the tensile stress in the substrate. Deformation occurs throughout the texture layer and is highly localized, resulting in multiple dome-shaped bumps 102 uniformly distributed throughout the texture layer, as indicated in Figures 5-7. Arrows in Figures 5 and 6 indicate stress directions, although stress has been relieved by bump formation. The bumps measure in the range of 1-3 microns in diameter, with a separation of about 3-5 microns between adjacent bumps. Density of the bumps ranges from about 3 X 10⁵ to about 12 X 10⁵ bumps/square centimeter. Bumps 102 provide in texture layer 42 an average roughness Ra of about 2 nm and maximum peak heights Rp in the range of from 7-18 nm.

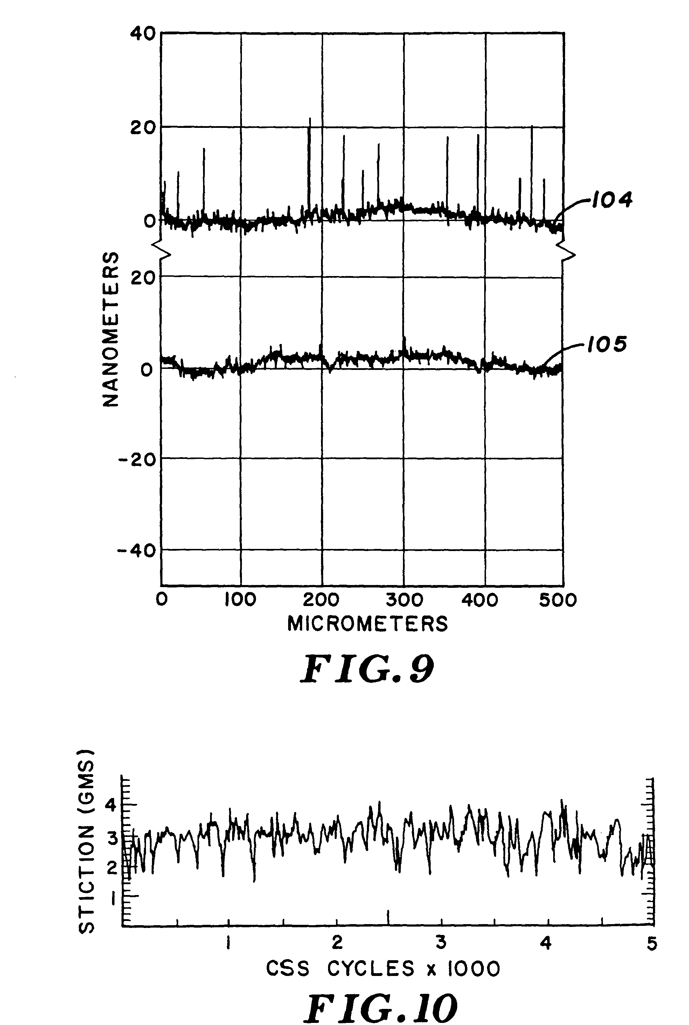

Figures 8 and 9 show Tencor measurements of disks having texture layers formed in the same manner as texture layer 42. The texture layer represented in Figure 8 was formed on an aluminum substrate. The profile, indicated at 103, reveals uniformity in peak heights, all of which are well below 20 nm. The disk represented in Figure 9 included a Pilkington smooth glass substrate. A profile 104 shows that most peak heights are below 20 nm, although peaks can equal or exceed that value. A profile 105, of the substrate before application of the texture layer, is shown for comparison with profile 104.

As an option, substrate 40 and texture layer 42 can be subjected to a further thermal cycle, in particular by operating heating element 76 to heat the substrate to a temperature of about 150° C., or in any event substantially less than the selected initial temperature for texture layer deposition. The additional thermal cycling tends to smooth out bumps 102, thus to enhance the wear characteristics of the contact zone.

After application and deformation of texture layer 42, substrate 40 is transferred to station 90 for deposition of chromium underlayer 44. Deposition in an argon atmosphere proceeds at a pressure of about 5-20 millitorr (0.66-2.66 Pa) and at a temperature of about 200 ° C., to apply underlayer 44 to a thickness of about 200 nm.

Next, substrate 40 is transferred to station 92 for application of thin film magnetic recording layer 46. Deposition proceeds at a pressure of about 10 millitorr (1.33 Pa) and at a temperature of about 150 ° C. Recording layer 46 is deposited to a thickness of about 20-40 nm. The crystalline structure of the magnetic recording layer tends to replicate the underlayer crystalline structure. Deposition occurs in an argon atmosphere.

Finally, the substrate is transferred to station 94 for application of protective carbon layer 48, preferably in an argon atmosphere at a pressure of 10 millitorr (1.33 Pa) and at a deposition temperature of 150° C. If hydrogenation of the carbon layer is desired, particularly near the upper surface, valve 74 is opened to introduce hydrogen.

Underlayer 44, magnetic recording layer 46 and protective layer 48 are deposited at respective uniform thicknesses. Accordingly, each layer tends to replicate the surface topography of the layer beneath it, with a slight tendency to round the bumps. Nonetheless, tencor profile measurements are substantially identical, whether taken immediately after deposition of the texture layer, or after the remaining layers have been added. The disk surface thus retains the dome-like bumps that provide the average roughness and peak height indicated above.

The formation of a texture by thermal cycling affords several advantages over previous texturing approaches, including simpler and much less expensive fabrication, reduced processing time, more repeatable results and results subject to control by varying several key process parameters. Fabrication cost and complexity are substantially reduced by elimination of a separate texturizing step (whether mechanical abrasion, etching or laser ablation) that would require treatment of the medium outside of the plasma chamber. As to processing speed, the size of textured areas can be increased without substantially increasing processing time, since the entire substrate and texture layer contract as they cool, regardless of their size. The resulting texture layer profiles exhibit a high degree of uniformity and consistency when applied under the same sputtering conditions, particularly sputtering pressure and temperature but also power level.

Sputtering conditions can be controlled to vary the nature of the bumps formed by texture layer deformation. In particular, increasing the thickness of the texture layer increases the size of the dome-shaped bumps. Bump size likewise can be increased by increasing the substrate temperature at the beginning of texture layer deposition. Longer cooling times lead to larger bumps. By contrast, increasing the argon pressure tends to reduce bump size. The density can be increased, i.e. the separation between adjacent bumps can be reduced, by preheating the substrate to a higher temperature just before sputtering. Finally, the topography depends on the texture layer material. Titanium and tungsten are highly preferred texturing materials, and the following alternative materials may be employed: chromium, aluminum, copper, lead, tin, gold, silver, and tantalum. Of course, the substrate material also influences topography since the build up of stresses depends upon the differences in the thermal expansion coefficients of the substrate and texture layer. Material surface energy also has been found to be a key consideration. In particular, for bump formation it is important that a surface energy of the texture material be higher than the surface energy of the substrate.

The following examples illustrate how results are influenced by the selection of materials and setting of parameters.

### Example 1

A titanium texture layer (thermal expansion coefficient of 8 X 10⁻⁶/degree C.) was sputter deposited onto a super smooth glass-ceramic substrate having a thermal expansion coefficient of 12 X 10⁻⁶/degree C. The respective surface energies of the Ti texture material and the glass-ceramic substrate are 1600 erg/cm² (1.6×10⁻⁴ Joule/cm²), and less than 730 erg/cm² (0.73×10⁻⁴ Joule/cm²). The substrate was preheated to a temperature of about 400° C., then removed from the heat source and allowed to cool during sputtering. Titanium was sputtered in an argon atmosphere at a pressure of 6 millitorr (0.80 Pa), and at a deposition rate of about 7 nm/second. Sputtering continued to a texture layer thickness of about 200 nm. The resulting bumps had diameters of about 2 micrometers and heights of about 15 nm. Bumps were formed at a density of about 5 X 10⁶/cm².

### Example 2

The conditions and materials were the same as in Example 1, except that the sputtering pressure was increased to 10 millitorr (1.33 Pa). The resulting bumps had diameters of about 1 micron, as compared to the 2 micron diameters of Example 1.

### Example 3

Conditions and materials were the same as in Example 1, except that the substrate was preheated to a temperature of about 500° C. The resulting bumps had a density of about 10 X 10⁶/square centimeter, about double the density of the bumps formed in Example 1.

### Example 4

Conditions and materials were the same as in Example 1, except that the Ti film was deposited to a thickness of about 300 nm. The thicker texture film resulted in bumps having heights of about 25 nm, as compared to the 15 nm height in Example 1.

### Example 5

Sputtering conditions and materials were the same as in Example 1, except that hydrogen gas (H₂ at less than 15%) was introduced during sputtering of the texture layer. Both bump height and bump size were reduced, due to the change in stress in the texture layer. Increasing the percentage of hydrogen, to values above 15% (atomic percent), further reduces bump size.

### Example 6

A Ti texturing material was sputter deposited onto a super smooth aluminum Ni-P substrate. The thermal expansion coefficient of the AlNiP substrate is 22 X 10⁻⁶/degree C. The surface energy of the substrate is less than 500 erg/cm² (0.5×10⁻⁴ Joule/cm²). The substrate was preheated to a temperature of about 300° C., then removed from the heat source to allow cooling during deposition. The titanium was deposited at a pressure of about 6 millitorr (0.80 Pa) and at a deposition rate of about 7 nm/second to a thickness of about 200 nm. The resulting bumps had diameters of about 3 microns and heights of about 20 nm. Bump density was about 7 X 10⁶/square centimeter.

### Example 7

Sputtering conditions and materials were the same as in Example 6, except that the pressure was increased to about 12 millitorr (1.60 Pa). Bump diameters were reduced from about 3 microns to about 1 micron.

### Example 8

Conditions and materials were the same as in Example 6, except that the substrate was preheated to a temperature of about 400° C. The bump density increased to about 12 X 10⁶/square centimeter.

### Example 9

Conditions and materials were the same as in Example 6, except that the Ti was sputtered to a thickness of about 300 nm. The bump height increased to about 35 nm.

### Example 10

Conditions and materials were the same as in Example 1, except that a tungsten texture layer was sputter deposited onto a glass-ceramic substrate. A much higher temperature was required (i.e. preheating to about 600° C.) The result was much larger bumps, having diameters of about 6 microns. Bump density was reduced to about 0.5 X 10⁴/square centimeter. The bump heights remained approximately the same.

Magnetic disks fabricated as discussed above have performed well under CSS testing. Figures 10-15 depict the results of testing two disks, one with a glass substrate tested for 5,000 start/stop cycles, and the other having an aluminum substrate and tested for 30,000 start/stop cycles. Values were measured at 20-cycle intervals in both cases.

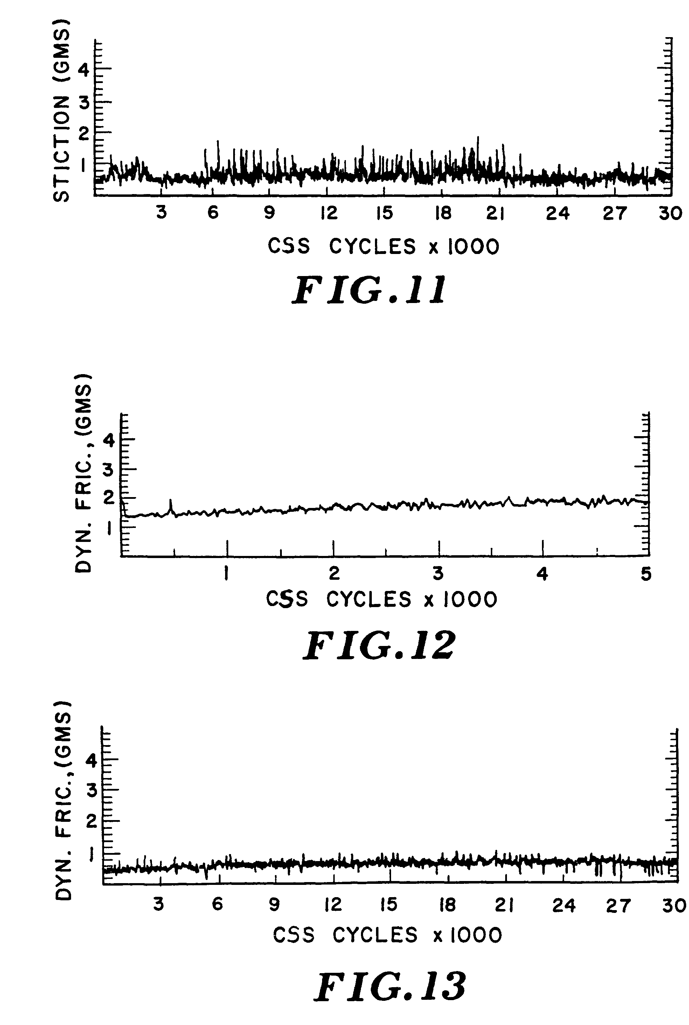

Figures 10 and 11 respectively illustrate stiction behavior of the disk with the aluminum substrate and the disk with the glass-ceramic substrate. Both disks have a glide avalanche of under 1.0 microinch (25.4 nm). More specifically, the value is 0.9 microinch (22.9 nm) for the AlNiP disk, and 0.74 microinch (18.8 nm) for the glass-ceramic disk. The first disk (glass-ceramic substrate) exhibited a final average stiction of 2.35 gms with a maximum stiction of 4.19 gms. The second disk (aluminum substrate) exhibited final average and maximum stiction values of 0.579 gms and 1.91 gms, respectively. Stiction remained substantially the same in both cases.

Figures 12 and 13 show the dynamic friction performance of the first and second disks, respectively. The first disk exhibited an initial dynamic friction of 1.56 gms, a final dynamic friction of 1.84 gms and a maximum dynamic friction of 2.25 gms. The second disk had an initial dynamic friction of 0.4 gms, a final dynamic friction of 0.735 gms and a maximum dynamic friction of 0.88 gms. The disks had respective friction coefficients of 0.749 gms and 0.187 gms.

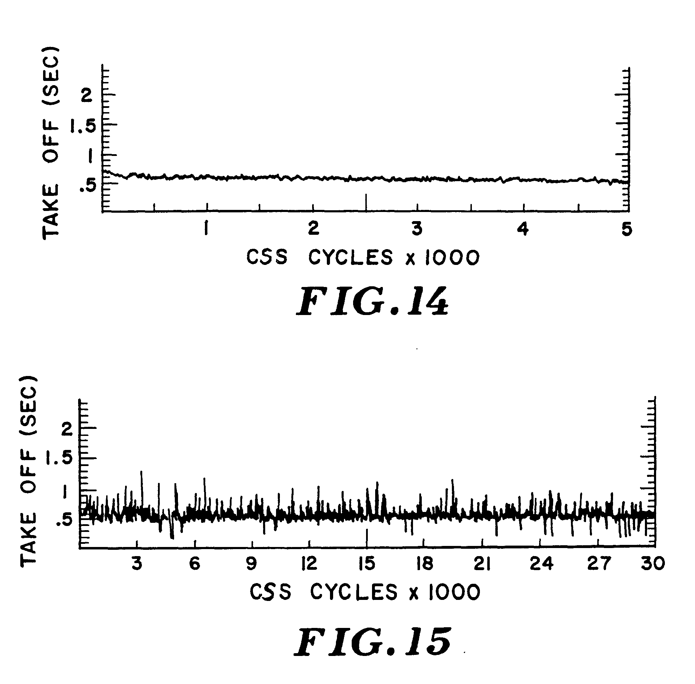

Both disks remained substantially constant as to take-off time, exhibiting final take-off times of 0.572 seconds and 0.558 seconds, respectively as seen in Figures 14 and 15.

The tested characteristics (stiction, wear and take-off time) revealed performance superior to that of conventional textured disks, and superior to other known texture approaches currently under development. The stiction values are about one-third to one-half of those for conventional mechanical texturing and the wear indices are about one-half those of conventionally textured disks. The take-off time is at most equal to, and frequently less than, that of other types of textured disks.

In general, CSS testing was performed at extremely low transducer flying heights, in the range of about 0.7 (17.8 nm) to about 1.0 microinch (25.4 nm) transducer flying heights as mentioned above. Despite flying heights of less than a microinch, the stiction and wear index values were very low and the take-off time was short, indicating a texture superior to conventional mechanical texture and other textures known to be currently under development. After CSS testing, the stiction and wear index values remained, within measurement error, unchanged. Thus the texturing is stable and has a high tolerance for CSS testing conditions and for normal operating conditions. Thus, testing has demonstrated excellent media performance under challenging conditions when texture layers are formed according to the present invention.

The disks further have exhibited excellent performance when tested for corrosion. In particular, when subjected to testing at 100% relative humidity at 80° C., the disks have shown good resistance to haze corrosion.

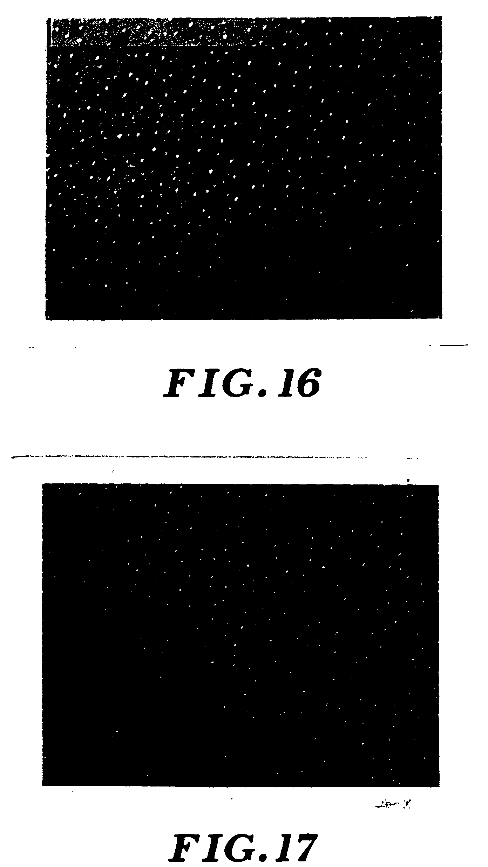

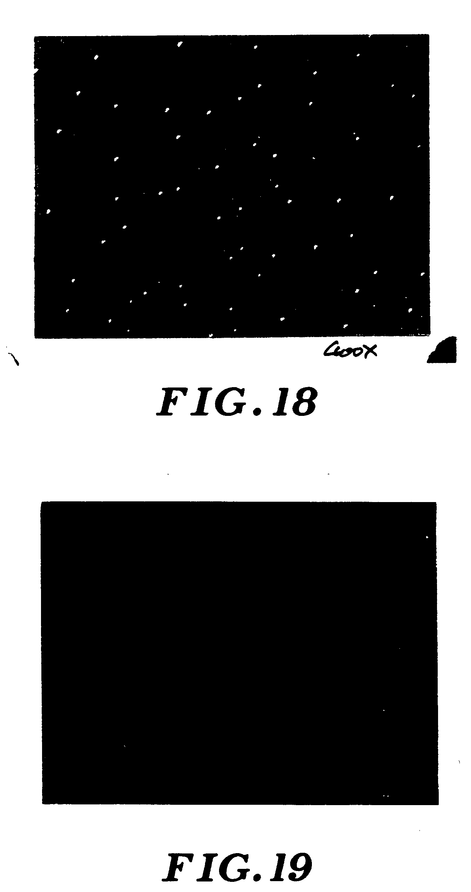

Texture layers, formed as explained, can be applied to virtually any type of non-magnetic substrate. Figures 16-19 are optical micrographs (magnification 400 X) showing texturing layers applied to different substrates including a polished aluminum nickel phosphorous substrate (Figure 16); a Canasite glass-ceramic substrate (Figure 17); an Ohara smooth glass ceramic substrate (Figure 18); and a Pilkington smooth glass substrate (Figure 19). The micrographs reveal the smooth, rounded nature of the bumps, and the degree of separation between neighboring bumps.

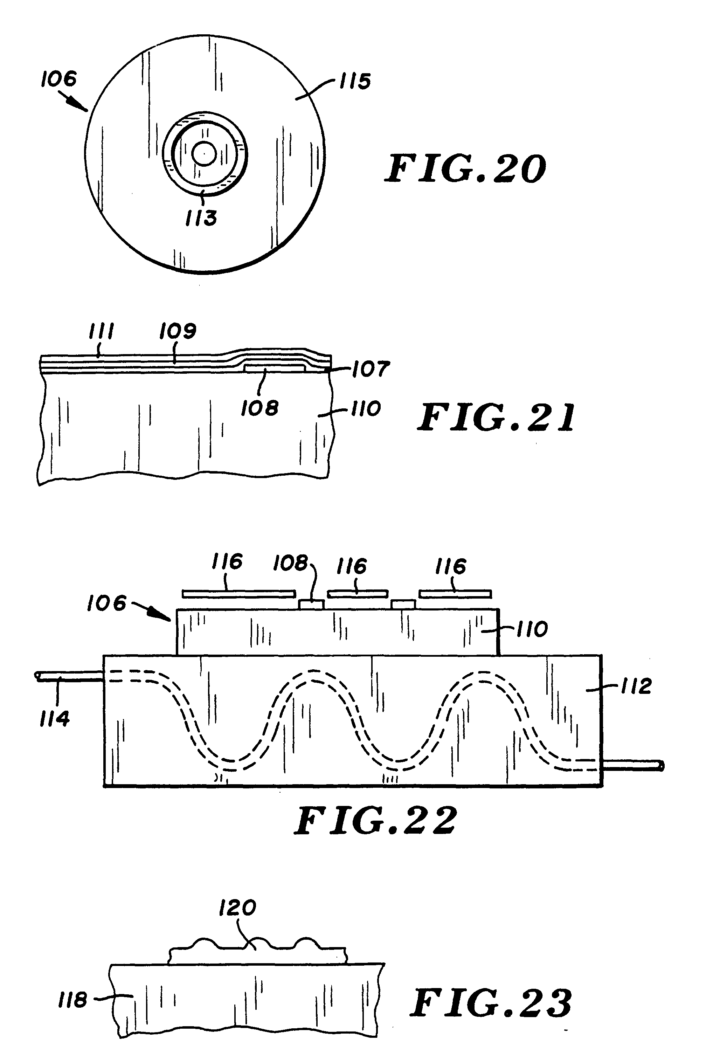

Figures 20 and 21 illustrate an alternative recording medium 106 fabricated with a fixture so that a texture layer 108 covers only an annular portion of the upper surface of a substrate 110. Further thin film layers include an underlayer 107, a magnetic recording layer 109 and a protective cover layer 111, substantially similar to their counterparts discussed above in connection with disk 16. As a result, the upper surface of medium 106 includes three annular regions: a radially inward region for clamping to a spindle as before, a dedicated transducing head contact zone 113, and an annular data zone 115 providing the area for recording and reading the magnetic data.

When medium 106 is in use at rest, a transducing head contacts the disk within contact zone 113. During data operations, the air cushion caused by medium rotation supports the transducing head at a desired glide height above data zone 115. When magnetic medium 106 is decelerated following an operation, the transducing head is moved radially inward to a position over contact zone 113, so that when coming to rest the head engages the contact zone. Before the next recording or retrieval operation, medium 106 is accelerated from stop, initially with the head and contact zone engaged. Once rotation is sufficient to support the transducing head with an air cushion, the head is moved to the intended position within the data zone.

The data and contact zones have different textures according to their respective functions. Data zone 115 preferably is polished or otherwise finished to a highly smooth, specular finish to permit the desired low transducing head glide height.
By contrast, contact zone 113 has a surface roughness greater than the data zone, i.e. in the range of from 7 to 18 nm. Roughness in this context means the height of the highest peaks above a nominal horizontal plane of the surface 18.

Fabrication of recording medium 106 proceeds as described above in connection with disk 16, with one exception. A fixture 116, preferably a metal shield, is disposed within the plasma chamber immediately above substrate 110. As illustrated in Figure 22, fixture 116 masks the substrate to restrict deposition of the texture layer to the intended annular region that becomes contact zone 113 in the finished medium.

Because substrate 110 and texture layer 108 are extremely thin axially (vertical in Figure 22) compared to their radial dimensions, they lose heat primarily in the axial direction. Accordingly, whether the texture layer is applied to the entire surface as shown in Figures 1 and 2, or just to a limited annular area intended as the contact zone, does not appreciably alter cooling time. However, cooling time can be reduced if desired by more rapidly extracting heat from a platform 112 that supports the substrate. For this purpose, a cooling coil 114 within the platform provides a path for transmitting a heat absorbing fluid (e.g. helium at low pressure) through the platform. This augments the tendency of platform 112 to act as a heat sink. The result is a more rapid cooling of substrate 110 and texture layer 42, which facilitates the use of substrate and texturing materials having less pronounced differences in their thermal expansion coefficients, and results in the formation of smaller bumps. Although shown in connection with limited texturing to provide a contact zone, platform 112 can just as well be employed when the texture layer covers the entire substrate surface.

Figure 23 illustrates an alternative substrate 118 and a texture layer 120 applied to the substrate. In this case, the substrate, formed of glass, has a linear coefficient of thermal expansion less than the thermal expansion coefficient of the texture layer. Thus, cooling substrate 118 and texture 120 would cause the texture layer to contract at the more rapid rate, whereupon tension rather than compression would be induced. Bumps would not form under these circumstances. Accordingly, texture layer 120 is applied by a low temperature deposition process, with no preheating of the substrate. The desired texture is obtained by heating the texture layer and substrate, to induce compression in the texture layer since it tends to expand more rapidly than the substrate in response to heating. Subsequent thin film layers are applied by vacuum deposition as explained above.

Thus in accordance with the present invention, a uniform, controlled texturing layer can be formed on a non-magnetic substrate in a relatively short time, regardless of whether the texture is limited to an intended contact zone or applied to the entire upper surface of the substrate. A high degree of repeatability and control is afforded by proper selection of parameters such as substrate temperature when deposition begins, deposition pressure, thickness of the texture layer and the substrate and texture layer materials.

## Claims

1. A process for forming a texture on a non-magnetic substrate (40), including:
providing a non-magnetic substrate (40) having a substantially planar and smooth substrate surface (50) and having a first linear coefficient of thermal expansion;
selecting a texturing material (42) having a second linear coefficient of thermal expansion different than the first linear coefficient of thermal expansion;
initiating a deposition of the texturing material over the substrate surface (50) when the substrate is at a selected initial temperature, and continuing the deposition to form a texture determining thin film (42) integral with the substrate: and
causing a change in the temperature of the substrate (40) away from the selected initial temperature to induce a mechanical stress in said thin film (42) due to the respective and different changes in dimensions of the substrate and thin film responsive to the temperature change, said induced mechanical stresses exceeding an elastic limit of the texturing material.

2. The process of claim 1 wherein:
said causing the change in substrate temperature, and said continuing of the deposition, occur simultaneously.

3. The process of claim 1 or 2 further including:
using a heat source (76) to heat the substrate (40), prior to the initiation of deposition, to a temperature at least as high as said initial temperature.

4. The process any preceding claim, wherein:
said initial temperature is above ambient temperature, preferably at least 200°C, preferably in the range of about 200° to 600°C, and most preferably in the range of 200° to 400°C.

5. The process of any preceding claim, wherein:
said causing of the change in substrate temperature comprises allowing the substrate (40) to cool.

6. The process of claim 5, wherein:
said cooling consists substantially of maintaining the substrate (40) and texturing material (42) in an ambient environment.

7. The process of any preceding claim, wherein:
said deposition comprises sputtering the texturing material over the substrate surface in a partial vacuum.

8. The process of claim 7 wherein:
said sputtering occurs within a vacuum chamber (52) at a deposition pressure in the range of about 3-50 millitorr (0.40-6.67 Pa).

9. The process of claim 7 or 8 wherein:
said deposition comprises sputtering the thin film to a thickness of less than about 5,000 angstroms (500nm).

10. The process of claim 9 wherein:
the thickness of the thin film (42) is in the range of about 500-3000 angstroms (50-300nm).

11. The process of any preceding claim, further including:
after completion of said deposition, and after the substrate temperature has moved toward an ambient level, heating the substrate (40) and thin film (42) to a reheat temperature of at least 150°C., then allowing the substrate and thin film to cool.

12. The process of any preceding claim, wherein:
said causing the change in the substrate temperature includes employing a heat sink to cool the substrate.

13. The process of any preceding claim further including:
after the change in the temperature, depositing at least one further material (44,46,48), preferably a magnetic recording material (46), onto the texture determining thin film to form a thin film layer having a uniform thickness to substantially replicate the surface topography of the texture determining thin film (42).

14. The process of any preceding claim, wherein:
said first linear thermal expansion coefficient is greater than said second linear thermal expansion coefficient whereby said mechanical stresses induced by cooling the substrate (40) and the thin film (42) are compressive stresses.

15. The process of any preceding claim, wherein:
the substrate (40) has a first surface energy, and the texturing material (42) has a second surface energy greater than the first surface energy.

16. A magnetic data storage medium comprising:
a non-magnetic substrate (40) having a substantially smooth substrate surface (50) and a first linear coefficient of thermal expansion;
a thin film texture layer (42) applied over the substrate surface (50) and integral with the substrate (40), said thin film texture layer including multiple local discontinuities formed by plastic deformation of the thin film (42) to relieve mechanical stresses induced in the thin film by temperature change of the substrate (40) and thin film (42), said discontinuities cooperating to define a surface roughness of the thin film; and
a magnetic thin film recording layer (46) applied over the thin film texture layer (42) at a substantially uniform thickness to provide a topography corresponding to the thin film texture layer topography.

17. The medium of claim 16 wherein:
said discontinuities consist substantially of smoothly rounded dome-like bumps (102).

18. The medium of claim 16 or 17 wherein:
said bumps (102) are distributed substantially uniformly, at a density in the range of about 300,000 to 1,200,000 bumps per square centimeter.

19. The medium of claim 16, 17 or 18 wherein:
said bumps (102) have maximum peak heights in the range of about 7-18 nm.

20. The medium of any of claims 16 to 19 further including:
a thin film underlayer (44) deposited onto the thin film texture layer (42) and disposed between the texture layer (42) and the thin film recording layer (46), and having a substantially uniform thickness with a topography corresponding to the topography of the texture layer.

21. The medium of claim 20 further including:
a protective cover layer (48) deposited onto the thin film recording layer (46).

22. The process according to any of claim 1 to 15, wherein:
said thin film texture layer (42) is comprised of at least one of the following elements: chromium, titanium, aluminum, tungsten, gold, silver and tantalum.

23. The process according to claim 22, wherein:
said thin film texture layer (42) consists essentially of a binary alloy formed of a pair of said elements.

24. The process according to any of claim 1 to 15, 22 and 23, wherein:
said substrate (40) consists essentially of one of the following materials: glass, a glass-ceramic, quartz, and aluminum plated with a nickel-phosphorous alloy.

25. The process according to any of claim 1 to 15 and 22 to 24 wherein:
said texture layer covers (42,108) only an annular segment of said substrate surface.

26. The process according to any of claim 1 to 15 and 22 to 24 wherein:
said texture layer (42) covers substantially all of said substrate surface.

27. The process according to any of claim 1 to 15 and 22 to 26, wherein:
said substrate surface (50) is substantially planar.

28. The medium according to any of claim 16 to 21, wherein:
said thin film texture layer (42) is comprised of at least one of the following elements:
chromium, titanium, aluminum, tungsten, gold, silver and tantalum.

29. The medium according to claim 28 wherein:
said thin film texture layer (42) consists essentially of a binary alloy formed of a pair of said elements.

30. The medium according to any of claim 16 to 21, 28 and 29, wherein:
said substrate (40) consists essentially of one of the following materials: glass, a glass-ceramic, quartz, and aluminum plated with a nickel-phosphorous alloy.

31. The medium according to any of claim 16 to 21 and 28 to 30 wherein:
said texture layer (42,108) covers only an annular segment of said substrate surface.

32. The medium according to any of claim 16 to 21 and 28 to 30 wherein:
said texture layer (42) covers substantially all of said substrate surface.

33. The medium according to any of claim 16 to 21 and 28 to 32, wherein:
said substrate surface (50) is substantially planar.

## Patentansprüche

1. Verfahren zur Formung einer Textur auf einem nichtmagnetischen Substrat (40), wobei das Verfahren folgendes einschließt:
Bereitstellen eines nichtmagnetischen Substrates (40) mit einer im wesentlichen ebenen und glatten Substratoberfläche (50) und mit einem ersten thermischen Längenausdehnungskoeffizienten,
Auswählen eines Texturierungsmaterials (42) mit einem zweiten thermischen Längenausdehnungskoeffizienten, der von dem ersten thermischen Längenausdehnungskoeffizienten verschieden ist,
Einleiten einer Abscheidung des Texturierungsmaterials über der Substratoberfläche (50), wenn sich das Substrat auf einer ausgewählten Anfangstemperatur befindet, und Fortsetzen der Abscheidung zur Bildung eines eine Textur bestimmenden Dünnfilmes (42) einstückig mit dem Substrat, und
Hervorrufen einer Änderung der Temperatur des Substrates (40) von der ausgewählten Anfangstemperatur fort, um eine mechanische Spannung in dem Dünnfilm (42) aufgrund der jeweiligen und unterschiedlichen Änderungen der Abmessungen des Substrates und des Dünnfilms in Abhängigkeit von der Temperaturänderung hervorzurufen, wobei die hervorgerufenen mechanischen Spannungen eine elastische Grenze des Texturierungsmaterials übersteigen.

2. Verfahren nach Anspruch 1, bei dem das Hervorrufen der Änderung der Substrattemperatur und die Fortsetzung der Abscheidung gleichzeitig erfolgen.

3. Verfahren nach Anspruch 1 oder 2, das weiterhin folgendes einschließt:
Verwenden einer Wärmequelle (76) zum Erhitzen des Substrates (40) vor der Einleitung der Abscheidung auf eine Temperatur, die zumindest so hoch ist, wie die Anfangstemperatur.

4. Verfahren nach einem der vorhergehenden Ansprüche, bei dem:
die Anfangstemperatur oberhalb der Umgebungstemperatur liegt, vorzugsweise um zumindest 200°C, vorzugsweise im Bereich von ungefähr 200°-600°C und am meisten bevorzugt in dem Bereich von 200°-400°C.

5. Verfahren nach einem der vorhergehenden Ansprüche, bei dem:
das Hervorrufen der Änderung der Substrattemperatur das Abkühlenlassen des Substrates (40) umfaßt.

6. Verfahren nach Anspruch 5, bei dem:
die Abkühlung im wesentlichen darin besteht, daß das Substrat (40) und das Texturierungsmaterial (42) unter Umgebungsbedingungen gehalten werden.

7. Verfahren nach einem der vorhergehenden Ansprüche, bei dem:
die Abscheidung das Zerstäuben von Texturierungsmaterial auf die Substratoberfläche in einem Teilvakuum umfaßt.

8. Verfahren nach Anspruch 7, bei dem:
die Zerstäubung in einer Vakuumkammer (52) bei einem Abscheidungsdruck im Bereich von ungefähr 30-50 Millitorr (0,40-6,67 Pa) erfolgt.

9. Verfahren nach Anspruch 7 oder 8, bei dem:
die Abscheidung die Zerstäubung des Dünnfilmes bis zu einer Dicke von weniger als ungefähr 5000 Å (500 nm) umfaßt.

10. Verfahren nach Anspruch 9, bei dem:
die Dicke des Dünnfilmes (42) im Bereich von ungefähr 500-3000 Å (50-300 nm) liegt.

11. Verfahren nach einem der vorhergehenden Ansprüche, das weiterhin folgendes einschließt:
nach dem Abschluß der Abscheidung und nachdem sich die Substrattemperatur in Richtung auf einen Umgebungstemperaturpegel bewegt hat, Erhitzen des Substrates (40) und des Dünnfilms (42) auf eine Wiedererhitzungstemperatur von zumindest 150° und nachfolgendes Abkühlenlassen des Substrates und des Dünnfilms.

12. Verfahren nach einem der vorhergehenden Ansprüche, bei dem:
das Hervorrufen der Änderung der Substrattemperatur die Verwendung einer Wärmesenke zum Abkühlen des Substrates einschließt.

13. Verfahren nach einem der vorhergehenden Ansprüche, das weiterhin folgendes einschließt:
nach der Änderung der Temperatur, Abscheiden von zumindest einem weiteren Material (44, 46, 48), vorzugsweise eines magnetischen Aufzeichnungsmaterials (46), auf dem die Textur bestimmenden Dünnfilm zur Bildung einer Dünnfilmschicht mit einer gleichförmigen Dicke, um im wesentlichen die Oberflächentopograpie des die Textur bestimmenden Dünnfilms (42) nachzubilden.

14. Verfahren nach einem der vorhergehenden Ansprüche, bei dem:
der erste thermische Längenausdehnungskoeffizient größer als der zweite thermische Längenausdehnungskoeffizient ist. so daß die durch die Abkühlung des Substrates (40) und des Dünnfilms (42) hervorgerufenen mechanischen Spannungen Kompressionsspannungen sind.

15. Verfahren nach einem der vorhergehenden Ansprüche, bei dem:
das Substrat (40) eine erste Oberflächenenergie aufweist und das Texturierungsmaterial (42) eine zweite Oberflächenenergie aufweist, die größer als die erste Oberflächenenergie ist.

16. Magnetisches Datenspeichermedium mit:
einem nichtmagnetischen Substrat (40) das eine im wesentlichen glatte Substratoberfläche (50) und einen ersten thermischen Längenausdehnungskoeffizienten aufweist,
eine Dünnfilm-Texturschicht (42), die über der Substratoberfläche (50) aufgebracht und mit dem Substrat (40) einstückig ist, wobei die Dünnfilm-Texturschicht mehrfache örtliche Diskontinuitäten einschließt, die durch eine plastische Verformung des Dünnfilms (42) zur Entspannung mechanischer Spannungen gebildet sind, die in dem Dünnfilm durch eine Temperaturänderung des Substrates (40) und des Dünnfilms (42) hervorgerufen wurden, wobei die Diskontinuitäten zusammenwirken, um eine Oberflächenrauhigkeit des Dünnfilms zu bilden, und
eine magnetische Dünnfilm-Aufzeichnungsschicht (46), die über der Dünnfilm-Texturschicht (42) mit einer im wesentlichen gleichförmigen Dicke aufgebracht ist, um eine Topographie zu schaffen, die der Topographie der Dünnfilm-Texturschicht entspricht.

17. Medium nach Anspruch 16, bei dem:
die Diskontinuitäten im wesentlichen aus sanft abgerundeten domförmigen Höckern (102) bestehen.

18. Medium nach Anspruch 16 oder 17, bei dem:
die Höcker (102) im wesentlichen gleichförmig mit einer Dichte im Bereich von ungefähr 30 0000 bis 1 200 000 Höckern pro cm² verteilt sind.

19. Medium nach Anspruch 16, 17 oder 18, bei dem:
die Höcker (102) maximale Spitzenhöhen im Bereich von ungefähr 7-18 nm aufweisen.

20. Medium nach einem der Ansprüche 16-19, das weiterhin folgendes einschließt:
eine Dünnfilm-Unterschicht (44), die auf die Dünnfilm-Texturschicht (42) abgeschieden und zwischen der Texturschicht (42) und der Dünnfilm-Aufzeichnungsschicht (46) angeordnet ist und eine im wesentlichen gleichförmige Dicke mit einer Topographie aufweist, die der Topographie der Texturschicht entspricht.

21. Medium nach Anspruch 20, das weiterhin folgendes einschließt:
eine schützende Deckschicht (48), die auf die Dünnfilm-Aufzeichnungsschicht (46) abgeschieden ist.

22. Verfahren nach einem der Ansprüche 1-15, bei dem:
die Dünnfilm-Texturschicht (42) aus zumindest einem der folgenden Elemente besteht: Chrom, Titan, Aluminium, Wolfram, Gold, Silber und Tantal.

23. Verfahren nach Anspruch 22, bei dem:
die Dünnfilm-Texturschicht im wesentlichen aus einer binären Legierung besteht, die aus einem Paar der Elemente gebildet ist.

24. Verfahren nach einem der Ansprüche 1-15, 22 und 23, bei dem:
das Substrat (40) im wesentlichen aus einem der folgenden Materialien besteht:
Glas, Glaskeramik, Quarz und Aluminium, das mit einer Nickel-Phosphor-Legierung plattiert ist.

25. Verfahren nach einem der Ansprüche 1-15 und 22-24, bei dem:
die Texturschicht (42, 108) lediglich ein ringförmiges Segment der Substratoberfläche bedeckt.

26. Verfahren nach einem der Ansprüche 1-15 und 22-24, bei dem:
die Texturschicht (42) im wesentlichen die gesamte Substratoberfläche bedeckt.

27. Verfahren nach einem der Ansprüche 1-15 und 22-26, bei dem:
die Substratoberfläche (50) im wesentlichen eben ist.

28. Medium nach einem der Ansprüche 16-21, bei dem:
die Dünnfilm-Texturschicht (42) aus zumindest einem der folgenden Elemente besteht: Chrom, Titan, Aluminium, Wolfram, Gold, Silber und Tantal.

29. Medium nach Anspruch 28, bei dem:
die Dünnfilm-Texturschicht (42) im wesentlichen aus einer binären Legierung besteht, die aus einem Paar der Elemente gebildet ist.

30. Medium nach einem der Ansprüche 16-21, 28 und 29, bei dem:
das Substrat (40) im wesentlichen aus einem der folgenden Materialien besteht: Glas, Glaskeramik, Quarz und Aluminium, das mit einer Nickel-Phosphor-Legierung plattiert ist.

31. Medium nach einem der Ansprüche 16-21 und 28-30, bei dem:
die Texturschicht (42, 108) lediglich ein ringförmiges Segment der Substratoberfläche bedeckt.

32. Medium nach einem der Ansprüche 16-21 und 28-30, bei dem:
die Texturschicht (42) im wesentlichen die gesamte Substratoberfläche bedeckt.

33. Medium nach einem der Ansprüche 16-21 und 28-32, bei dem:
die Substratoberfläche (50) im wesentlichen eben ist.

## Revendications

1. Procédé destiné à créer une texture sur un substrat non magnétique (40), comprenant les étapes consistant à :
proposer un substrat non magnétique (40) présentant une surface de substrat (50) essentiellement plane et lisse et possédant un premier coefficient linéaire de dilatation thermique ;
choisir une matière de texturation (42) possédant un second coefficient linéaire de dilatation thermique différent du premier coefficient linéaire de dilatation thermique ;
commencer à réaliser un dépôt de la matière de texturation sur la surface de substrat (50) lorsque le substrat se trouve à une température initiale choisie, et poursuivre le dépôt afin de créer une couche mince déterminant une texture (42) d'un seul tenant avec le substrat ; et
provoquer une variation de la température du substrat (40) de façon à ce qu'elle s'éloigne de la température initiale choisie pour provoquer une contrainte mécanique dans ladite couche mince (42) en raison des différentes variations respectives de dimensions du substrat et de la couche mince en réponse à la variation de température, lesdites contraintes mécaniques provoquées excédant une limite élastique de la matière de texturation.

2. Procédé selon la revendication 1, dans lequel :
ladite étape de provocation de la variation de la température du substrat et ladite étape de poursuite du dépôt se produisent simultanément.

3. Procédé selon la revendication 1 ou la revendication 2, comprenant en outre :
l'utilisation d'une source de chaleur (76) afin de chauffer le substrat (40), avant le début du dépôt, pour atteindre une température au moins aussi élevée que ladite température initiale.

4. Procédé selon l'une quelconque des revendications précédentes, dans lequel :
ladite température initiale est supérieure à la température ambiante, d'au moins 200°C de préférence, dans la plage comprise entre environ 200°C et 600°C de préférence, et de manière préférée dans la plage comprise entre 200°C et 400°C.

5. Procédé selon l'une quelconque des revendications précédentes, dans lequel :
ladite étape consistant à provoquer la variation de la température du substrat comprend l'étape consistant à laisser le substrat (40) refroidir.

6. Procédé selon la revendication 5, dans lequel :
ledit refroidissement consiste essentiellement à maintenir le substrat (40) et la matière de texturation (42) dans un environnement ambiant.

7. Procédé selon l'une quelconque des revendications précédentes, dans lequel :
ledit dépôt comprend la pulvérisation de la matière de texturation sur la surface du substrat dans un vide partiel.

8. Procédé selon la revendication 7, dans lequel :
ladite pulvérisation a lieu à l'intérieur d'une chambre à vide (52) sous une pression de dépôt dans la plage allant de 0,40 à 6,67 Pa environ (3 à 50 millitorrs).

9. Procédé selon la revendication 7 ou la revendication 8, dans lequel :
ledit dépôt comprend la pulvérisation de la couche mince à une épaisseur inférieure à 500 nm environ (5000 angströms).

10. Procédé selon la revendication 9, dans lequel :
l'épaisseur de la couche mince (42) se trouve dans la plage allant de 50 à 300 nm environ (500 à 3000 angströms).

11. Procédé selon l'une quelconque des revendications précédentes, comprenant en outre :
après l'achèvement dudit dépôt, et après que la température du substrat a été élevée pour atteindre un niveau ambiant, le chauffage du substrat (40) et de la couche mince (42) pour obtenir une température de réchauffage d'au moins 150°C, puis l'étape consistant à laisser le substrat et la couche mince refroidir.

12. Procédé selon l'une quelconque des revendications précédentes, dans lequel :
ladite étape consistant à provoquer le changement de la température du substrat comprend l'utilisation d'une source froide pour refroidir le substrat.

13. Procédé selon l'une quelconque des revendications précédentes, comprenant en outre :
après la variation de température, le dépôt d'une autre matière (44, 46, 48) au minimum, de préférence un matériau d'enregistrement magnétique (46), sur la couche mince déterminant la texture afin de créer une strate de couche mince présentant une épaisseur uniforme dans le but de reproduire sensiblement la topographie superficielle de la couche mince déterminant la texture (42).

14. Procédé selon l'une quelconque des revendications précédentes, dans lequel :
ledit premier coefficient linéaire de dilatation thermique est supérieur audit second coefficient linéaire de dilatation thermique, moyennant quoi lesdites contraintes mécaniques provoquées par le refroidissement du substrat (40) et de la couche mince (42) sont des contraintes de compression.

15. Procédé selon l'une quelconque des revendications précédentes, dans lequel :
le substrat (40) possède une première énergie superficielle, et la matière de texturation (42) possède une seconde énergie superficielle supérieure à la première énergie superficielle.

16. Support de mémorisation de données magnétique comprenant :
un substrat non magnétique (40) présentant une surface de substrat (50) essentiellement lisse et un premier coefficient linéaire de dilatation thermique ;
une couche texturée formant couche mince (42) appliquée sur la surface du substrat (50) et formant un seul tenant avec le substrat (40), ladite couche texturée formant couche mince comprenant de multiples discontinuités locales créées par une déformation plastique de la couche mince (42) afin d'atténuer des contraintes mécaniques provoquées dans la couche mince par une variation de température du substrat (40) et de la couche mince (42), lesdites discontinuités coopérant pour définir une rugosité superficielle de la couche mince ; et
une couche d'enregistrement de couche mince magnétique (46) appliquée au-dessus de la couche texturée formant couche mince (42) d'une épaisseur essentiellement uniforme afin de proposer une topographie correspondant à la topographie de la couche texturée formant couche mince.

17. Support selon la revendication 16, dans lequel :
lesdites discontinuités se composent essentiellement de bosses (102) uniformément arrondies, ressemblant à des dômes.

18. Support selon la revendication 16 ou la revendication 17, dans lequel :
lesdites bosses (102) sont pour l'essentiel uniformément réparties, d'une densité dans la plage allant de 300 000 à 1 200 000 bosses environ par centimètre carré.

19. Support selon la revendication 16, 17 ou 18, dans lequel :
lesdites bosses (102) présentent des hauteurs de pic maximales dans la plage allant de 7 à 18 nm.

20. Support selon l'une quelconque des revendications 16 à 19, comprenant en outre :
une sous-couche de couche mince (44) déposée sur la couche texturée formant couche mince (42) et disposée entre la couche texturée (42) et la couche d'enregistrement de couche mince (46), et présentant une épaisseur essentiellement uniforme avec une topographie correspondant à la topographie de la couche texturée.

21. Support selon la revendication 20, comprenant en outre :
une couche de revêtement de protection (48) déposée sur la couche d'enregistrement de couche mince (46).

22. Procédé selon l'une quelconque des revendications 1 à 15, dans lequel :
ladite couche texturée formant couche mince (42) se compose au moins d'un des éléments suivants: chrome, titane, aluminium, tungstène, or, argent et tantale.

23. Procédé selon la revendication 22, dans lequel :
ladite couche texturée formant couche mince (42) se compose essentiellement d'un alliage binaire formé de deux desdits éléments.

24. Procédé selon l'une quelconque des revendications 1 à 15, 22 et 23, dans lequel :
ledit substrat (40) se compose essentiellement d'une des matières suivantes : verre, vitrocéramique, quartz et aluminium galvanisé avec un alliage nickel-phosphore.

25. Procédé selon l'une quelconque des revendications 1 à 15 et 22 à 24, dans lequel :
ladite couche texturée (42, 108) recouvre uniquement un segment annulaire de ladite surface de substrat.

26. Procédé selon l'une quelconque des revendications 1 à 15 et 22 à 24, dans lequel :
ladite couche texturée (42) recouvre sensiblement la totalité de ladite surface de substrat.

27. Procédé selon l'une quelconque des revendications 1 à 15 et 22 à 26, dans lequel :
ladite surface de substrat (50) est sensiblement plane.

28. Support selon l'une quelconque des revendications 16 à 21, dans lequel :
ladite couche texturée formant couche mince (42) se compose au moins d'un des éléments suivants: chrome, titane, aluminium, tungstène, or, argent et tantale.

29. Support selon la revendication 28, dans lequel :
ladite couche texturée formant couche mince (42) se compose essentiellement d'un alliage binaire formé de deux desdits éléments.

30. Support selon l'une quelconque des revendications 16 à 21, 28 et 29, dans lequel :
ledit substrat (40) se compose essentiellement d'une des matières suivantes : verre, vitrocéramique, quartz et aluminium galvanisé avec un alliage nickel-phosphore.

31. Support selon l'une quelconque des revendications 16 à 21 et 28 à 30, dans lequel :
ladite couche texturée (42, 108) recouvre uniquement un segment annulaire de ladite surface de substrat.

32. Support selon l'une quelconque des revendications 16 à 21 et 28 à 30, dans lequel :
ladite couche texturée (42) recouvre sensiblement la totalité de ladite surface de substrat.

33. Support selon l'une quelconque des revendications 16 à 21 et 28 à 32, dans lequel :
ladite surface de substrat (50) est sensiblement plane.
